Europäisches Patentamt

European Patent Office

Office européen des brevets

(11) Publication number: **0 177 103**
**B1**

(12) EUROPEAN PATENT SPECIFICATION

(45) Date of publication of patent specification: **10.05.89**

(51) Int. Cl.⁴: **H 03 K 17/62,** H 03 F 3/72

(21) Application number: **85201570.0**

(22) Date of filing: **30.09.85**

(54) Electronic switch.

(30) Priority: **03.10.84 NL 8403012**

(43) Date of publication of application:
**09.04.86 Bulletin 86/15**

(45) Publication of the grant of the patent:
**10.05.89 Bulletin 89/19**

(84) Designated Contracting States:
**AT BE CH DE FR GB IT LI LU NL SE**

(56) References cited:
**GB-A-2 041 684**
**US-A-3 106 646**
**US-A-3 441 809**
**US-A-3 657 562**
**US-A-4 000 428**

(73) Proprietor: **ALCATEL N.V.**
**Strawinskylaan 537 (World Trade Center)**
**NL-1077 XX Amsterdam (NL)**

(72) Inventor: **Waalboer, Henny**
**Wingerdpark 89**
**NL-2724 RC Zoetermeer (NL)**

(74) Representative: **van der Beek, George Frans**
**et al**
**Nederlandsch Octrooibureau Scheveningseweg**
**82 P.O. Box 29720**
**NL-2502 LS 's-Gravenhage (NL)**

## Description

The invention relates to an electronic switch comprising an input stage with a first transistor of which the base through a matching network is connected to the input of the switch, an output stage with a second transistor and a switching stage with a third transistor of which the emitter-collector path is connected in between a power supply terminal and the emitter of the first transistor, and of which the base is connected to the control input of the switch.

An electronic switch of this type is described in the U.S. Patent 4,000,428. In this prior art electronic switch both the first as well as the second transistor are functioning as emitter follower. The emitter-collector path of the switching transistor is connected to the emitter of the first transistor, which emitter furthermore through a resistor is connected to the base of the second transistor. If a relatively high voltage is supplied to the base of the switching transistor, said switching transistor is brought in the completely conducting state with the result that the emitter voltage of the first transistor decreases underneath the base voltage of said first transistor, which base voltage is determined by the matching network between the input of the switch and the base of the first transistor. The result thereof is that the first transistor will not conduct. Furthermore because the switching transistor is completely conductive also the voltage potential on the base of the second transistor is decreased.

Said electronic switch is destined for application in an array of switches whereby the output electrodes of all second transistors are connected to one common resistor, whereby it is assumed that at any time one of the electronic switches is "closed", in other words that the second transistor of the related switch is conducting. In that case the current flowing through the emitter-collector path of the second transistor of the closed switch will cause a voltage drop across the load resistor such that the emitters of all transistors will be maintained at a predetermined voltage potential. By bringing the switching transistors of all other "open" switches completely in conduction the voltage potential onto the base of said second transistors will in a correctly dimensioned circuit be lower than the voltage potential on the emitter thereof and therefore also the second transistors of the "open" switches will not conduct.

A first disadvantage of said known electronic switch is that in the "open" or non-signal conducting condition of the switch said switch draws a significant current caused by the completely conducting status of the switching transistor. In an array of n switches of which at any time only one switch is closed, the remaining n−1 switches will together draw a not neglectable current out of the thereto destine power unit.

A further disadvantage of said known switch is that this switch in fact is not suited for very high frequencies. It is indicated in said U.S. Patent that additional resistors are connected in series with the base of each of the first and second transistors to prevent oscillations at higher frequencies in the order of 100 MHz.

Another disadvantage is that the blocking action viewed from the output of the switch to the input thereof is not sufficient to prevent that especially very high frequency signals, which appear at the output through another momentaneously "closed" switch, reach the input of the switch. Such a feedback phenomena is very disadvantageous because the result thereof is that signals out of the broadband spectrum at the output are able to reach the input which is in the intended application very undesirable.

An object of the invention is now to eliminate the above indicated disadvantages at least as good as possible. In agreement with said object the electronic switch of the above indicated type is characterized in that the first transistor is operated in a common emitter circuit, whereby the collector through a matching transformer and through a forward biased diode is connected to the input electrode of a second transistor operating in common base circuit, of which second transistor the output electrode is connected to the output of the switch, whereas the emitter-collector path of the switching transistor is on the one hand connected in series with the collector-emitter path of the first transistor and is on the other hand connected to the junction between said matching transformer and said diode.

If the input of the switching transistor receives such a signal that the switching transistor becomes non conductive, then because of the relatively high voltage across the emitter-collector path of the switching transistor the diode between the matching transformer and the input electrode of the second transistor will become blocked so that no current (and therewith no signal) can flow through the second transistor. Furthermore the potential voltage on the emitter of the first transistor may increase to above the voltage potential on the base thereof so that also the first transistor is not conducting. Together this forms an effective signal blocking. In said "open" or no signal conducting condition of the switch only a very small current is supplied to the switch by the thereto destined power unit.

In case the input of the switching transistor receives such a signal that the switching transistor is brought into the conducting state, then the voltage drop across the emitter-collector path of the switching transistor will decrease such that on the one hand the first transistor will be brought into the conducting state and on the other hand also the diode and therewith the second transistor will be conductive so that the switch is effectively signal conducting or "closed".

The matching transformer between the first and second transistor takes care of an impedance conversion between both transistors. Especially in case the transformation ratio of said transformer is equal to N:1, whereby n is larger than 1, said transistor adds a significant contribution to the backwards signal attenuation from the output of the switch to the input thereof.

Preferably the switch is embodied such that in the connection between the emitter-collector path of the switching transistor and the collector-emitter path of the first transistor at least a further forward biased diode is inserted. In case the switching transistor is non-conducting also said diode will be non-conducting so that it is guaranteed that no current will flow through the first transistor.

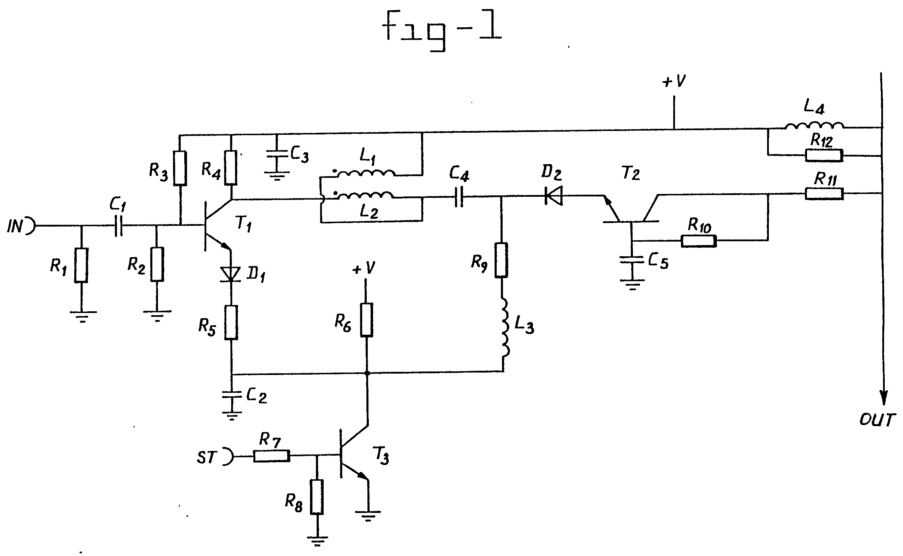

The invention will now be described in more detail with reference to the embodiments illustrated in the attached Figures 1, 2 and 3.

The embodiment of the electronic switch illustrated into the Figure comprises three transistors T1, T2 and T3. The input stage with the first transistor T1 comprises furthermore the bias resistors R2 and R3 and the input network comprising R1 and C1. The collector of T1 is through the matching transformer L1/L2 connected to the power supply terminal +V. A resistor R4, which has no function for the DC biasing of transistor T1 is connected in parallel to the matching transformer. Said resistor has a number of functions. In the first place said resistor prevents eventual very high frequent parasitic oscillations in the circuit. The combination of R5 and R4 parallel to the transformer determines the amplification factor of the first stage practically independent of tolerances in the transformer parameters. Furthermore the resistor R4 is of interest for the input and transfer characteristic of T1. In the "open" condition of the switch said resistor R4 prevents a too high impedance at the collector of T1 and plays therefore an important role in relation to the feedback attenuation. The resistor R4 decreases the feedback in the circuit both in the "open" as well as in the "closed" condition.

The emitter of T1 is through a diode D1 and a resistor R5 connected to the collector of the transistor T3. Said diode D1 is not always necessary. If it is omitted then measures have to be taken to prevent a too high voltage reaching T1 and to guarantee that said transistor remains correctly biased under all circumstances. The base of transistor T3 is connected to earth through a resistor R8 and is connected to the control input ST through resistor R7. The collector of transistor T3 is on the one hand through resistor R6 connected to the power supply terminal +V and on the other hand through an inductive element (a coil) L3 and a resistor R9 connected to the junction between the coupling capacitor C4 and a diode D2. The capacitor C4 is in the illustrated manner connected to the matching transformer L1/L2. In most cases also the coil L3 can be eliminated without any objections in most cases.

The diode D2, preferably a PIN-type diode, is in turn coupled to the emitter of the output transistor T2, which is operated in a common base circuit. The base of said transistor is through an h.f. bypass capacitor C5 connected to earth and furthermore connected to the collector through a resistor R10. From said collector a resistor R11 is connected to the output OUT of the electronic switch. The value of R10 is selected such that a good temperature stability and a properly variable current gain factor stability of T2 is obtained.

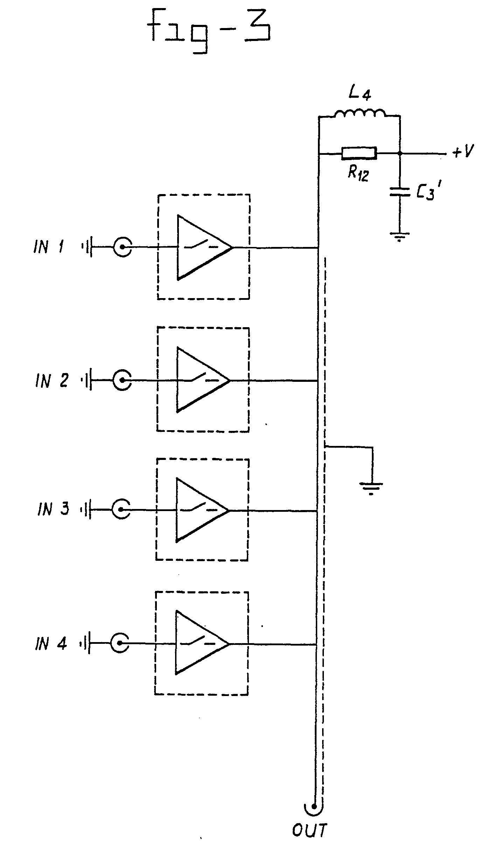

The resistor R12 parallel to the coil L4 functions especially as terminating resistor of the common output line OUT. In case an array of switches is used as is illustrated in Figure 3, whereby the output line OUT is used as common output line for each of said switches then only one combination of components L4/R12 is connected to the output line.

In case a relatively high input voltage, e.g. approximating the power supply voltage +V, is delivered to the control input ST of the switch, then the switching transistor T3 will become completely conducting, so that the voltage potential of the collector T3 will practically become equal to earth potential. In that case a current will flow from the voltage supply terminal +V through L4, the resistor R11, the transistor T2, the diode D2, the resistor R9 and the coil L3 through the transistor T3 to earth. Because through the resistor R10 the base of transistor T2 is through the resistor R10 connected to the collector of transistor T2 in this case also the diode D2 will be switched conducting. Also the transistor T1 will switch into the conducting state, whereby the current path runs from the power supply terminal +V through the transformer L1/L2, the collector-emitter path of T1, the conducting diode D1, the resistor R5 and the transistor T3 to earth. The resistors R2 and R3 deliver such a bias voltage to the base of transistor T1 that in this case said transistor will be switched into the conducting state together with diode D1.

In this situation therefore a high frequency input signal appearing at the input IN of the switch will through the capacitor T1 be applied to the base of T1. Thereafter the signal will be transferred through the transformer L1/L2 and the capacitor C4 to the output stage transistor T2. From the collector of transistor T2 and through the resistor R11 the signal reaches the output OUT.

If the control input ST of the switching transistor T3 is switched to a relatively low potential level, e.g. the earth potential, then transistor T3 will not conduct. In that case the potential level at the collector of T3 will increase to approximately the power supply voltage potential +V so that D2 will not conduct and no current will run through T2. That alone forms already an effective signal blocking between the input and the output of the switch. However, also the diode D1 will not conduct so that no current flow is possible through T1 and depending onto the biasing conditions also the transistor T1 (even in case D1 is not present) will be switched into the non-conducting state.

For high frequency signals the collector of T3 is connected to earth through the h.f. bypass capacitor C2. It is preferred that D1 is a diode with a high reverse capacity, so that in case the switch is open and no high frequency signals may pass through the switch, an increased high frequency bypass to earth is obtained through the non conductive diode. If D1 is omitted, then said discoupling is obtained directly through R5 and C2.

The capacitor C3 is used as high frequency bypass capacitor for the power supply voltage.

Preferably the winding ratio of the transformer L1/L2 is selected as n:1, whereby n is larger than 1. The ratio is selected such that in the "closed" condition of the switch an optimum signal isolation is obtained between the output and the input. Said choice will not lead to an optimum matching between T1 and T2. The resulting gain loss can be equalized by changing the gain of T1.

The high frequent choke-coil L3 prevents that signals, which are transferred through C4 to the output stage around T2, are reaching the switching transistor T3. Dependent on the dimensioning of the other components (R9 should be selected large enough) it is however, in many cases possible to omit the choke-coil L3.

Preferably for the resistor R11 such a resistance value is selected that therewith the influence of the imaginary capacitive component of T2, viewed from the output OUT, is strongly reduced, which further prevents any feedback from the output to the input of the switch. R11 causes only a minor signal loss because, disregarding the collector capacity, T2 can be considered approximately as an ideal current source.

Although in Figure 1 the transistors T1 and T2 are illustrated as bipolar transistors in this circuit also field effect transistors of the J-FET type can be used. In that case a further reduction of the number of components can be realized.

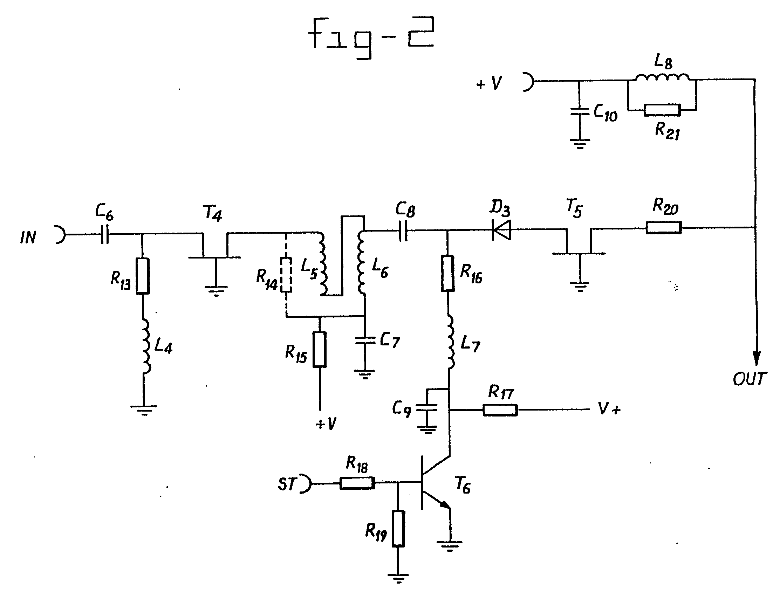

An embodiment comprising two J-FET's is illustrated in Figure 2. The control stage around transistor T6 is completely identical to the corresponding stage around T3 in Figure 1. Also the functions of the resistors R16, R17, R18 and R19 as well as the functions of the capacitor C9 and the coil L7 are completely identical.

The input stage comprises now only the J-FET T4, the capacitor C6, the resistor R13 and the coil L4. Through the input IN and the transistor T4 the input signal reaches the transformer L5/L6 which transfers the signals through the capacitor C8 and the diode D3 to the transistor T5 which is also embodied as J-FET. Through the resistor R20 the signal reaches then the output OUT. The power supply voltage V+ for the first stage around T4 is supplied through the resistor R15 and is h.f. bypassed through the capacitor C7. The resistor R14 resulting into an additional damping of the transformer L5/L6 can be omitted eventually. The same applies to the coil L7. Furthermore just as in Figure 1 also in this Figure 1 h.f. bypass network is present connected to the output and realized by the resistor R21, the coil L8 and the capacitor C10.

Because the functioning of the complete circuit is exactly the same as the functioning of the circuit in Figure 1 a further discussion of the circuit in Figure 2 is considered as superfluous. It is only remarked that for the transistor T4 preferably a FET is selected for which applies $1/S \approx 15V/mA$, resulting into an input impedance of approximately $75\Omega$ for the switch as a whole.

The input stage around T1 respectively around T4 will realize a certain signal amplification of the high frequency signal and the gain is preferably adjusted such that the attenuation of the signal in the output stage is in principle compensated such that the switch as a whole between the input IN and the output OUT has a transfer damping of 0 dB.

It will be clear that within the scope of the invention various amendments and modifications are possible without leaving the scope of the following claims.

**Claims**

1. Electronic switch comprising an input stage with a first transistor (T1) of which the base is connected to the input (IN) of the circuit through a matching network, an output stage with a second transistor (T2) and a switching stage with a third transistor (T3) of which the emitter-collector path is connected in between a power supply terminal and the emitter of the first transistor, and of which the base is connected to the control input (ST) of the switch, characterized in that the first transistor (T1) is operated in a common emitter circuit, whereby the collector through a matching transformer (L1/L2) and through a forward biased diode (D2) is connected to the input electrode of a second transistor (T2) operating in common base circuit, of which second transistor the output electrode is connected to the output (OUT) of the switch, whereas the emitter-collector path of the third transistor (T3) is on the one hand connected in series with the collector-emitter path of the first transistor and is on the other hand connected to the junction between said matching transformer and said diode.

2. Electronic switch according to claim 1, characterized in that in the connection between the emitter-collector path of the switching transistor and the collector-emitter path of the first transistor (T1) at least a further forward biased diode (D1) is inserted.

3. Electronic switch according to one of the preceding claims, characterized in that in the connection between the emitter-collector path of the switching transistor and said junction between the transformer and the diode an inductive element (L3) is inserted.

4. Electronic switch according to one of the preceding claims, characterized in that the first and second transistor are J-FET's.

5. Electronic switch according to one of the preceding claims, characterized in that the matching transformer has a transformation ratio of n:1, whereby n is larger than 1.

6. Electronic switch according to one of the preceding claims, characterized in that the gain of the input stage is adjusted such that it compensates the attenuation in further parts of the switch so that the switch as a whole has a transfer damping of approximately 0 dB.

**Patentansprüche**

1. Elektronischer Schalter, der eine Eingangsstufe mit einem ersten Transistor (T1), dessen Basis mit dem Eingang (IN) über ein Anpassungsnetzwerk verbunden ist, eine Ausgangsstufe mit einem zweiten Transistor (T2) und eine Schaltstufe mit einem dritten Transistor (T3), dessen Emitter-—Kollektor—Pfad zwischen einem Stromversorgungsanschluß und dem Emitter des ersten Transistors angeschlossen ist und dessen Basis mit dem Steuereingang (ST) des Schalters verbunden ist, enthält, dadurch gekennzeichnet, daß der erste Transistor (T1) in gemeinsamer Emitterschaltung arbeitet, wobei der Kollektor über einen Anpassungsübertrager (L1/L2) und über eine in Durchlaßrichtung vorgespannte Diode (D2) mit der Eingangselektrode des zweiten Transistors (T2) verbunden ist, der in gemeinsamer Basisschaltung arbeitet und dessen Ausgangselektrode mit dem Ausgang (OUT) des Schalters verbunden ist, während der Emitter—Kollektor—Pfad des dritten Transistors (T3) einerseits in Serie mit dem Kollektor-Emitter-Pfad des ersten Transistors und andererseits mit dem Verbindungspunkt zwischen genanntem Übertrager und genannter Diode verbunden ist.

2. Elektronischer Schalter nach Anspruch 1, dadurch gekennzeichnet, daß zwischen den Emitter—Kollektor—Pfad des Schalttransistors und den Kollektor—Emitter—Pfad des ersten Transistors (T1) mindestens eine weitere, in Durchlaßrichtung vorgespannte, Diode (D1) geschalt ist.

3. Elektronischer Schalter nach einem der vorgenannten Ansprüche, dadurch gekennzeichnet, daß zwischen dem Emitter—Kollektor—Pfad des Schalttransistors und dem Verbindungspunkt zwischen dem genannten Übertrager und der genannten Diode ein induktives Element (L3) geschaltet ist.

4. Elektronischer Schalter nach ·einem oder mehreren der vorgehannten Ansprüche, dadurch gekennzeichnet, daß der erste und zweite Transistor J-FET's sind.

5. Elektronischer Schalter nach einem oder mehreren der vorgenannten Ansprüche, dadurch gekennzeichnet, daß der Anpassungsübertrager ein Übertragungsverhältnis n:1 aufweist, wobei n größer ist als 1.

6. Elektronischer Schalter nach einem ·oder mehreren der vorgenannten Ansprüche, dadurch gekennzeichnet, daß die Verstärkung der Eingangstufe derart eingestellt ist, daß sie die Dämpfung in den folgenden Teilen des Schalters kompensiet, so daß der Schalter insgesamt eine Übertragungsdämpfung von etwa 0 dB hat.

**Revendications**

1. Commutateur électronique comprenant un étage d'entrée avec un premier transistor (T1) dont la base est connectée à l'entrée (IN) du circuit par un réseau d'adaptation, un étage de sortie avec un deuxième transistor (T2) et un étage de commutation avec un troisième transistor (T3) dont le trajet émetteur-collecteur est connecté entre une borne d'alimentation et l'émetteur du premier transistor, et dont la base est connecté à l'entrée de commande (ST) du commutateur, caractérisé en ce que le premier transistor (T1) est utilisé en un circuit à émetteur commun dans lequel le collecteur est connecté, par l'intermédiaire d'un transformateur adaptateur (L1/L2) et d'une diode polarisée dans le sens passant (D2), à l'électrode d'entrée d'un deuxième transistor (T2) utilisé dans un circuit à base commune, l'électrode sortie de ce deuxième transistor étant connectée à la sortie (OUT) du commutateur, tandis que le trajet émetteur-collecteur du troisième transistor (T3) est, d'une part, connecté en série avec le trajet collecteur-émetteur du premier transistor et, d'autre part, connecté à la jonction entre ledit transformateur adaptateur et ladite diode.

2. Commutateur électronique conforme à la revendication 1, caractérisé en ce que, dans la connexion entre le trajet émetteur-collecteur du transistor de commutation et le trajet collecteur-émetteur du premier transistor (T1), est insérée au moins une autre diode (D1) polarisée dans le sens passant.

3. Commutateur électronique conforme à l'une des revendications précédentes, caractérisé en ce que, dans la connexion entre le trajet émetteur-collecteur du transistor de commutation et ladite junction entre le transformateur et la diode, il est insérée un élément inductif (L3).

4. Commutateur électronique conforme à l'une des revendications précédentes, caractérisé en ce que le premier et le deuxième transistors sont des transistors J-FET.

5. Commutateur électronique conforme à l'une des revendications précédentes, caractérisé en ce que le transformateur adaptateur a un rapport de transformation de n/1, n étant plus gratation de n/1, n étant plus grand que 1.

6. Commutateur électronique conformé à l'une des revendications précédentes, caractérisé en ce que le gain de l'étage d'entrée est ajusté de manière à ce qu'il compense l'atténuation dans les autres parties du commutateur, de sortie que le commutateur ait globalement un amortissement de transfer d'approximativement 0 dB.

fig-1

1

fig-2

EP 0 177 103 B1

# Fig-3